(19)

Europäisches Patentamt
European Patent Office
Office européen des brevets

(11) **EP 2 418 697 A2**

(12) **EUROPEAN PATENT APPLICATION**

(43) Date of publication:
**15.02.2012 Bulletin 2012/07**

(21) Application number: **11157657.5**

(22) Date of filing: **10.03.2011**

(51) Int Cl.:
*H01L 33/08* (2010.01)   *H01L 33/12* (2010.01)
*H01L 33/04* (2010.01)   *H01L 33/06* (2010.01)
*H01L 33/00* (2010.01)   *H01L 33/32* (2010.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **09.08.2010 JP 2010178534**

(71) Applicant: **Kabushiki Kaisha Toshiba
Tokyo (JP)**

(72) Inventors:
• **Shioda, Tomonari
  Minato-ku
  Tokyo (JP)**

• **Nunoue, Shinya
  Minato-ku
  Tokyo (JP)**
• **Tachibana, Koichi
  Minato-ku
  Tokyo (JP)**
• **Harada, Yoshiyuki
  Minato-ku
  Tokyo (JP)**
• **Hikosaka, Toshiki
  Minato-ku
  Tokyo (JP)**

(74) Representative: **Granleese, Rhian Jane
Marks & Clerk LLP
90 Long Acre
London
WC2E 9RA (GB)**

(54) **Semiconductor light emitting device**

(57)     According to one embodiment, a semiconductor light emitting device (110) includes: semiconductor layers; a multilayered structural body (40); and a light emitting portion (30). The multilayered structural body (40) is provided between the semiconductor layers, and includes a first layer (41) and a second layer (42) including In. The light emitting portion (30) is in contact with the multilayered structural body (40) between the multilayered structural body (30) and p-type semiconductor layer (20), and includes barrier layers (31) and a well layer (32) including In with an In composition ratio among group III elements higher than an In composition ratio among group III elements in the second layer (42). An average lattice constant of the multilayered structural body (40) is larger than that of the n-type semiconductor layer (10). Difference between the average lattice constant of the multilayered structural body (40) and that of the light emitting portion (30) is less than difference between that of the multilayered structural body (40) and that of the n-type semiconductor layer (10).

FIG. 1

**Description**

<u>FIELD</u>

Embodiments described herein relate generally to a semiconductor light emitting device.

<u>BACKGROUND</u>

Nitride semiconductors are used in semiconductor light emitting devices such as light emitting diodes (LED), laser diodes (LD), and the like. Crystal defects occur easily and luminous efficiency decreases when there is strain in crystals of light emitting portions of active layers that are provided between n-type semiconductor layers and p-type semiconductor layers of a semiconductor light emitting device.

<u>BRIEF DESCRIPTION OF THE DRAWINGS</u>

FIG. 1 is a schematic cross-sectional view illustrating a semiconductor light emitting device according to the embodiment;
FIG. 2 is a graph illustrating the characteristics of semiconductor light emitting devices; and
FIGS. 3A to 3C are schematic cross-sectional views illustrating the characteristics of semiconductor light emitting devices.

<u>DETAILED DESCRIPTION</u>

In general, according to one embodiment, a semiconductor light emitting device includes an n-type semiconductor layer including a nitride semiconductor, a p-type semiconductor layer including a nitride semiconductor, a multilayered structural body and a light emitting portion. The multilayered structural body is provided between the n-type semiconductor layer and the p-type semiconductor layer. The multilayered structural body includes a plurality of first layers and a second layer provided between the plurality of first layers. The second layer includes In. A light emitting portion is in contact with the multilayered structural body between the multilayered structural body and the p-type semiconductor layer. The light emitting portion includes a plurality of barrier layers and a well layer provided between the plurality of barrier layers. The well layer includes In with an In composition ratio among group III elements higher than an In composition ratio among group III elements in the second layer. An average lattice constant of the multilayered structural body along an axis in a first direction perpendicular to a stacking direction from the n-type semiconductor layer toward the p-type semiconductor layer being larger than an average lattice constant of the n-type semiconductor layer along an axis in the first direction. An absolute value of a difference between the average lattice constant of the multilayered structural body and an average lattice constant of the light emitting portion along an axis in the first direction is less than an absolute value of a difference between the average lattice constant of the multilayered structural body and the average lattice constant of the n-type semiconductor.

Various embodiments will be described hereinafter with reference to the accompanying drawings.

Note that the drawings are schematic or simplified illustrations and that relationships between thicknesses and widths of parts and proportions in size between parts may differ from actual parts. Also, even where identical parts are depicted, mutual dimensions and proportions may be illustrated differently depending on the drawing.

Note that in the drawings and specification of this application, the same numerals are applied to elements that have already appeared in the drawings and been described, and repetitious detailed descriptions of such elements are omitted.

(Embodiment)

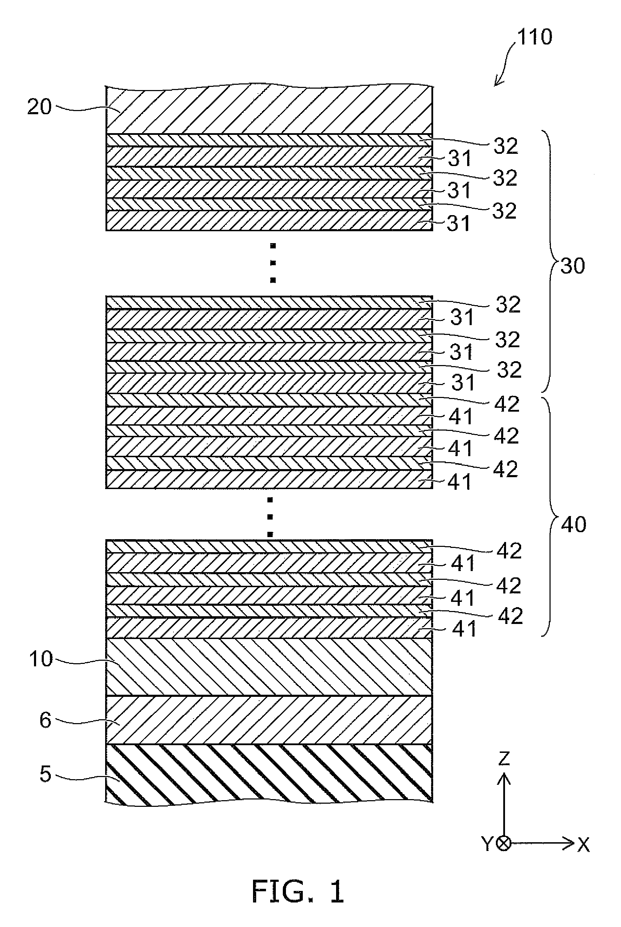

FIG. 1 is a schematic cross-sectional view illustrating the configuration of a semiconductor light emitting device according to an embodiment.

As illustrated in FIG. 1, a semiconductor light emitting device 110 according to the embodiment includes an n-type semiconductor layer 10, a p-type semiconductor layer 20, a multilayered structural body 40, and a light emitting portion 30.

The n-type semiconductor layer 10 and the p-type semiconductor layer 20 include nitride semiconductors.

The multilayered structural body 40 is provided between the n-type semiconductor layer 10 and the p-type semiconductor layer 20. The multilayered structural body 40 includes a plurality of first layers 41 and second layers 42 including In and provided between each of the plurality of first layers 41. A nitride semiconductor including group III elements can be used for the first layers 41 and the second layers 42.

The light emitting portion 30 is in contact with the multilayered structural body 40 between the multilayered structural body 40 and the p-type semiconductor layer 20. The light emitting portion 30 includes a plurality of barrier layers 31 and well layers 32 provided between each of the plurality of barrier layers 31. A nitride semiconductor including group III elements can be used for the barrier layers 31 and the well layers 32.

An In composition ratio among group III elements in the first layers 41 is lower than an In composition ratio among group III elements in the well layers 32. GaN that is substantially free of In is used, for example as the first layers 41.

An In composition ratio among group III elements in the second layers 42 is lower than an In composition ratio in the group III element in the well layers 32. InGaN, and the like, having a lower In composition ratio than the well layers 32 is used for the second layers 42.

An In composition ratio among group III elements in the barrier layers 31 is lower than an In composition ratio among group III elements in the well layers 32. Thereby, a band gap energy of the barrier layers 31 becomes larger than a band gap energy of the well layers 32. For example, GaN or InGaN is used for the barrier layers 31 and InGaN or the like is used for the well layers 32.

Thus, the In composition ratio among group III elements in the first layers 41, the In composition ratio among group III elements in the second layer 42, and the In composition ratio among group III elements in the barrier layers 31 are lower than the In composition ratio among group III elements in the well layer 32. That is, the well layers 32 include In with the In composition ratio among group III elements higher than the In composition ratio among group III elements in the second layers 42. The first layers 41 and the barrier layers 31 include In with an In composition ratio among group III elements lower than the In composition ratio among group III elements in the well layers 32. "an In composition ratio among group III elements lower than the In composition ratio among group III elements in the well layers 32" includes a case where the layer does not include In.

Here, a stacking direction from the n-type semiconductor layer 10 toward the p-type semiconductor layer 20 is defined as a Z-axis direction. One direction perpendicular to the Z-axis direction is defined as an X axis direction (first direction). A direction perpendicular to the Z-axis direction and perpendicular to the X-axis direction is defined as a Y-axis direction.

An average lattice constant of the multilayered structural body 40 along an axis in the first direction is larger than an average lattice constant of the n-type semiconductor layer 10 along the axis in the first direction.

For example, an absolute value of a difference between the average lattice constant of the multilayered structural body 40 along the axis in the first direction and an average lattice constant of the light emitting portion 30 along the axis in the first direction is less than an absolute value of a difference between the average lattice constant of the multilayered structural body 40 along the axis in the first direction and the average lattice constant of the n-type semiconductor layer 10 along the axis in the first direction.

For example, when a nitride semiconductor having a Wurtzite crystal structure is being crystal grown in c-axis direction, the Z-axis direction becomes the c-axis direction and the first direction becomes, for example, a-axis direction. The first direction may also, for example, be m-axis direction.

Hereinafter, a case is described where the average lattice constant of the multilayered structural body 40 along the axis in the first direction is an average lattice constant of the multilayered structural body 40 along the a-axis, the average lattice constant of the n-type semiconductor layer 10 along the axis in the first direction is an average lattice constant of the n-type semiconductor layer 10 along the a-axis, and the average lattice constant of the light emitting portion 30 along the axis in the first direction is an average lattice constant of the light emitting portion 30 along the a-axis.

Here, the average lattice constant is an average lattice spacing in a crystal layer calculated based on a diffraction image of the crystal layer obtained through x-ray diffraction. The average lattice constant, for example, is calculated using a reciprocal lattice map (reciprocal space map).

For example, the average lattice constant of the light emitting portion 30 along the a-axis is substantially equivalent to the average lattice constant of the multilayered structural body 40 along the a-axis. In other words, a lattice of the light emitting portion 30 is coherent (commensurate) with a lattice of the multilayered structural body 40. The coherent state includes states of quasi-matched (pseudomorphic) lattices. Specifically, the lattice of the light emitting portion 30 and the lattice of the multilayered structural body 40 are continuous, and occurrences of misfit defects (i.e., dislocations) caused by differences in the lattice constants are suppressed in the light emitting portion 30.

Thereby, crystal strain in the light emitting portion 30 can be suppressed. Thereby, crystal defects can be suppressed, which leads to an improvement in luminous efficiency. Furthermore, a piezoelectric effect of the light emitting portion 30 can be suppressed, and thus luminous efficiency is improved.

As illustrated in FIG. 1, the semiconductor light emitting device 110 can further include a substrate 5 provided on a side of the n-type semiconductor layer 10 opposite to the multilayered structural body 40 and a buffer 6 provided between the substrate 5 and the n-type semiconductor layer 10. As described hereinafter, for example, the buffer 6 is formed on the substrate 5, a crystal of the n-type semiconductor layer 10 is grown on the buffer layer 6, a crystal of the multilayered structural body 40 is formed on the n-type semiconductor layer 10, a crystal of the light emitting portion 30 is formed on the multilayered structural body 40, and a crystal of the p-type semiconductor layer 20 is formed on the light emitting portion 30. The substrate 5 and the buffer layer 6 may be removed after the crystal growth described above.

For example, the first layer 41 is disposed on a side closest to the n-type semiconductor layer 10 in the multilayered structural body 40. Then, the second layers 42 and the first layers 41 are alternately stacked. Then, the second layer 42 is disposed on a side closest to the light emitting portion 30 in the multilayered structural body 40.

For example, the barrier layer 31 is disposed on a side closest to the multilayered structural body 40 in the light emitting portion 30. Then, the barrier layers 31 and the well layers 32 are alternately stacked. Then, the barrier layer 31 is further disposed on a side closest to the p-type semiconductor layer 20 in the light emitting portion 30.

When a GaN layer (n-type semiconductor layer 10) is used as the substrate 5 and an InGaN layer (the well layer 32) is grown thereon, a lattice mismatch difference will be large and defects will easily occur. Additionally, when the InGaN layer is grown while having strain, an internal electric field of the InGaN layer having strain will be large, and the effects thereof will prevent highly efficient luminescence from being obtained.

In the embodiment, a multilayered structural body 40 is formed having a larger average lattice constant in the a-axis direction than that of the n-type semiconductor layer 10 of a base layer, and the emitting portion 30 that is coherent with an outermost surface of the multilayered structural body 40 is grown thereon. Thereby, strain in the light emitting portion 30 is reduced and highly efficient luminescence is obtained. The new configuration of the embodiment was constructed based on a phenomenon which was newly discovered through experiments done by the inventors.

The experiments are described hereinafter.

Hereinafter, an example of a manufacturing method for the semiconductor light emitting device 110 is described.

Metal-organic vapor phase epitaxy (MOVPE) is used for the growing of the semiconductor crystals included in the semiconductor light emitting device 110.

A substrate having a sapphire (0001) plane as a major surface, for example, is used as the substrate 5. Thermal cleaning of the substrate 5 is performed at, for example, a susceptor temperature of 1100°C.

The susceptor temperature is lowered to 500°C and a crystal of the buffer layer 6 is grown on the substrate 5. A GaN layer, for example, is used for the buffer layer 6.

The susceptor temperature is raised to 1120°C. In this state, a crystal of the n-type semiconductor layer 10 is grown. A GaN layer, for example, is used for the n-type semiconductor layer 10. The n-type semiconductor layer 10 is, for example, a high temperature growth GaN layer. This GaN layer will become a base layer for the crystal growth of the multilayered structural body 40.

In the description recited above, aside from the substrate having the sapphire (0001) plane, a SiC substrate or a GaN substrate may be used for the substrate 5. Additionally, a substrate having a plane other than the sapphire (0001) plane may be used for the substrate 5.

A carrier gas is changed from $H_2$ to $N_2$ and the susceptor temperature is lowered to 810°C. Then, a crystal of a GaN layer that will become the first layers 41 is grown. A thickness of the first layers 41 is, for example, 3.15 nanometers (nm). Furthermore, a crystal of, for example an $In_{0.1}Ga_{0.9}N$ layer that will become the second layer 42 is grown. A thickness of the second layer 42 is, for example, 1 nm.

Ten cycles of such a combination of the first layer 41 and the second layer 42 (in other words, ten of the first layers 41 and ten of the second layers 42) are formed. Thereby, the multilayered structural body 40 is formed.

The growing is interrupted, the susceptor temperature is raised to 850°C, and a GaN layer that will become the barrier layer 31 is grown. A thickness of the barrier layer 31 is, for example, 14.5 nm. The thickness of the barrier layer 31 is preferably set to be not less than 3 nm and not more than 20 nm. If the thickness of the barrier layer 31 is large, there will be a tendency for flatness to improve, but if the thickness of the barrier layer 31 exceeds 20 nm, strain in the barrier layer 31 will become too large. If the thickness of the barrier layer 31 is less than 3 nm, the flatness of the surface will be insufficient. $N_2$ is preferably used as the carrier gas when the susceptor temperature in the forming of the barrier layer 31 is in a range not less than 900°C and not more than 1000°C. However, crystal quality can be improved by adding $H_2$ to the carrier gas.

Thereafter, the susceptor temperature is lowered to a temperature of not less than 700°C and not more than 850°C and, for example, an $In_{0.2}Ga_{0.8}N$ layer that will become the well layer 32 is grown. A thickness of the well layer 32 is, for example, 2.5 nm. An optimal growth temperature will vary depending on the In composition ratio. For example, for blue LED applications having low In composition ratios, not less than 780°C and not more than 850°C is preferable. For green LED application having high In composition ratios, from 700°C to 800°C is preferable.

Four cycles of such a combination of the barrier layer 31 and the well layer 32 (in other words, four of the barrier layers 31 and four of the well layers 32) are formed. Furthermore, the barrier layer 31 served as the nearest one to the p-type semiconductor layer 20 is formed on an uppermost well layer 32. Thereby, the light emitting portion 30 is formed.

In the description recited above, a growth temperature of the barrier layers 31 is preferably higher than a growth temperature of the well layers 32. By setting the growth temperature of the barrier layers 31 higher than the growth temperature of the well layers 32, a generation of pits in the GaN layers of the barrier layers 31 is suppressed. The growth temperature of the barrier layers 31 is higher than the growth temperature of the well layers 32 and a difference between the growth temperature of the barrier layers 31 and the growth temperature of the well layers 32 is preferably 200°C or less. By setting the difference between the growth temperature of the barrier layers 31 and the growth temperature of the well layers 32 to 200°C or less, degradation of the InGaN layers of the well layers 32 is suppressed.

Thereafter, the susceptor temperature is set to 970°C and an Mg doped AlGaN layer is grown. Then, an Mg doped GaN layer is grown at 970°C and a GaN layer doped with a high concentration of Mg is grown at 970°C. The Mg doped AlGaN layer, the Mg doped GaN layer, and the GaN layer doped with a high concentration of Mg are included in the p-type semiconductor layer 20.

After the growing of the crystals as described above, the substrate 5 on which the crystals have grown is removed from the reaction chamber, electrode forming is performed, chipping is performed. Thus, light emitting diodes were fabricated.

Hereinafter, semiconductor light emitting devices of reference examples are described.

A semiconductor light emitting device 119a of a first reference example (not shown) does not have the multilayered structural body 40 as in the semiconductor light emitting device 110. In the semiconductor light emitting device 119a of the first reference example, in terms of the manufacturing method described above, the forming of the multilayered structural body 40 (the forming of the first layers 41 and the second layers 42) is not performed. Instead, the light emitting portion 30 is formed on the n-type semiconductor layer 10 (the forming of the barrier layers 31 and the well layers 32). Aside from this condition, conditions were the same as in the semiconductor light emitting device 110.

A semiconductor light emitting device 119b of a second reference example (not shown) has a multilayered structural body 40 similar to the semiconductor light emitting device 110. However, a configuration of the multilayered structural body 40 differs from that of the semiconductor light emitting device 110. Specifically, in the semiconductor light emitting device 119b, $In_{0.08}Ga_{0.92}N$ was used for the first layers 41. A thickness of the first layers 41 is 1 nm. Conditions of the second layers 42 were the same as in the semiconductor light emitting device 110. Moreover, in the semiconductor light emitting device 119b, twenty cycles of a combination of the first layer 41 and the second layer 42 (twenty of the first layers 41 and twenty of the second layers 42) were formed. Aside from these conditions, conditions (i.e. condition of the light emitting portion 30 and the like) were the same as in the semiconductor light emitting device 110.

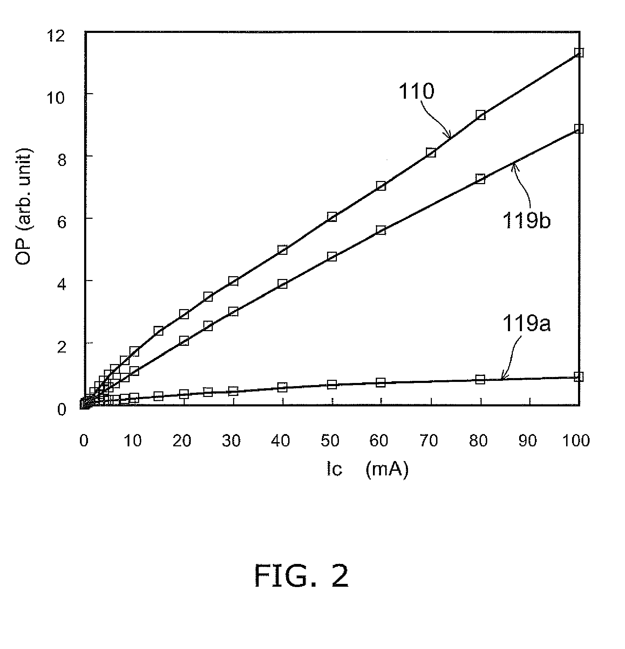

FIG. 2 is a graph illustrating the characteristics of semiconductor light emitting devices.

Specifically, this graph shows the results of evaluations of the characteristics of the semiconductor light emitting devices 110, 119a, and 119b described above. The horizontal axis shows an input current Ic (milliamperes: mA) and the vertical axis shows a luminescence output (OP), which is an arbitrary unit.

As illustrated in FIG. 2, the luminescence output OP of the semiconductor light emitting device 119a of the first reference example is low. As the multilayered structural body 40 is not provided in the semiconductor light emitting device 119a, it is considered that the decrease in the crystal quality of the light emitting portion 30 is caused by the lattice mismatch of a difference between the lattice constant of the GaN of the n-type semiconductor layer 10 and the lattice constant of the light emitting portion 30 including In.

The luminescence output OP of the semiconductor light emitting device 119b of the second reference example is higher than in the semiconductor light emitting device 119a. As the multilayered structural body 40 is provided, it is considered that this is caused by an improvement of the crystal quality of the light emitting portion 30 due to a relaxation of the lattice mismatch between the n-type semiconductor layer 10 and the light emitting portion 30 by the multilayered structural body 40. However, the improvement of the luminescence output OP in the semiconductor light emitting device 119b is insufficient.

On the other hand, the luminescence output OP of the semiconductor light emitting device 110 according to the embodiment is higher than that of the semiconductor light emitting device 119a and higher than that of the semiconductor light emitting device 119b. Thus, in the semiconductor light emitting device 110 according to the embodiment, a large luminescence output OP can be obtained.

In the semiconductor light emitting device 110, the crystal quality of the light emitting portion 30 is even higher than that of the semiconductor light emitting device 119b.

Hereinafter, results of an analysis of the characteristics of crystals of a semiconductor light emitting device are described.

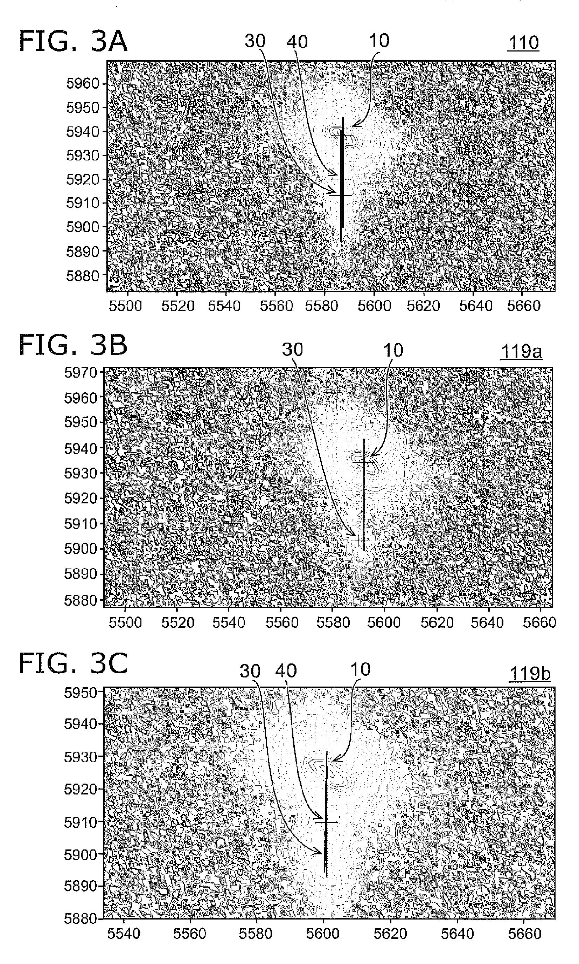

FIGS. 3A to 3C are schematic cross-sectional views illustrating the characteristics of semiconductor light emitting devices.

Specifically, these drawings are (204) reciprocal lattice maps showing measurement results of the lattice constants of the n-type semiconductor layer 10, multilayered structural body 40, and light emitting portion 30 for the semiconductor light emitting devices 110, 119a, and 119b described above. In each drawing, the horizontal axis represents a reciprocal of a lattice spacing in a horizontal direction (the first direction) with respect to the major surface of the substrate 5. The vertical axis represents a reciprocal of a lattice spacing in a perpendicular direction (Z-axis direction) with respect to the major surface of the substrate 5. In other words, the horizontal axis is an index of the reciprocal of the lattice constant in the a-axis direction, and the vertical axis is an index of the reciprocal of the lattice constant in the c-axis direction.

Average lattice constants of the n-type semiconductor layer 10, the multilayered structural body 40, and the light emitting portion 30 can be obtained from the reciprocal lattice map.

As illustrated in FIG. 3A, in the semiconductor light emitting device 110 according to the embodiment, the average lattice constant of the multilayered structural body 40 along the a-axis is larger than the average lattice constant of the n-type semiconductor layer 10 along the a-axis. Moreover, the average lattice constant of the light emitting portion 30 along the a-axis is substantially equivalent to the average lattice constant of the multilayered structural body 40 along the a-axis. A difference between the average lattice constant of the multilayered structural body 40 along the a-axis and the average lattice constant of the n-type semiconductor layer 10 along the a-axis is 90 ppm when based on the average lattice constant of the n-type semiconductor layer 10 along the a-axis. A difference between the average lattice constant of the light emitting portion 30 along the a-axis and the average lattice constant of the n-type semiconductor layer 10 along the a-axis is 86 ppm when based on the average lattice constant of the n-type semiconductor layer 10 along the a-axis. If errors in measurements are taken into consideration, it can be considered that the average lattice constant of the light emitting portion 30 along the a-axis is consistent with the average lattice constant of the multilayered structural body 40 along the a-axis.

Thus, in the semiconductor light emitting device 110, an absolute value (in this example, 4 ppm) of the difference between the average lattice constant of the multilayered structural body 40 along the a-axis and the average lattice constant of the light emitting portion 30 along the a-axis is less than an absolute value (in this example, 90 ppm) of the difference between the average lattice constant of the multilayered structural body 40 along the a-axis and the average lattice constant of the n-type semiconductor layer 10 along the a-axis.

As illustrated in FIG. 3B, in the semiconductor light emitting device 119a of the first reference example, the average lattice constant of the light emitting portion 30 along the a-axis is larger than the average lattice constant of the n-type semiconductor layer 10 along the a-axis, and the difference between the average lattice constant of the light emitting portion 30 along the a-axis and the average lattice constant of the n-type semiconductor layer 10 along the a-axis is 358 ppm when based on the average lattice constant of the n-type semiconductor layer 10 along the a-axis,. Thus, in the semiconductor light emitting device 119a, the average lattice constant of the light emitting portion 30 along the a-axis is a value that greatly differs from the average lattice constant of the n-type semiconductor layer 10 being the base layer along the a-axis. Therefore, it is considered that the luminescence output is low as a result of the occurrence of lattice mismatch and the decline in crystal quality.

As illustrated in FIG. 3C, in the semiconductor light emitting device 119b of the second reference example, the difference between the average lattice constant of the multilayered structural body 40 along the a-axis and the average lattice constant of the n-type semiconductor layer 10 along the a-axis is 37 ppm when based on the average lattice constant of the n-type semiconductor layer 10 along the a-axis. The difference between the average lattice constant of the light emitting portion 30 along the a-axis and the average lattice constant of the n-type semiconductor layer 10 along the a-axis is 133 ppm when based on the average lattice constant of the n-type semiconductor layer 10 along the a-axis.

Thus, in the semiconductor light emitting device 119b of the second reference example, an absolute value (in this example, 96 ppm) of the difference between the average lattice constant of the multilayered structural body 40 along the a-axis and the average lattice constant of the light emitting portion 30 along the a-axis is larger than an absolute value (in this example, 37 ppm) of the difference between the average lattice constant of the multilayered structural body 40 along the a-axis and the average lattice constant of the n-type semiconductor layer 10 along the a-axis.

In the semiconductor light emitting device 119b of the second reference example, the average lattice constant of the multilayered structural body 40 along the a-axis is set to an intermediate value between the average lattice constant of the n-type semiconductor layer 10 along the a-axis and the average lattice constant of the light emitting portion 30 along the a-axis. Therefore, a first lattice mismatch between the n-type semiconductor layer 10 and the multilayered structural body 40 and a second lattice mismatch between the multilayered structural body 40 and the light emitting portion 30 exist. It is considered that, due to the second lattice mismatch (the lattice mismatch between the multilayered structural body 40 and the light emitting portion 30), strain is generated in the light emitting portion 30, the crystal quality of the light emitting portion 30 decreases, and, as a result, the luminescence output OP became insufficient.

On the other hand, in the semiconductor light emitting device 110 according to the embodiment, a lattice mismatch exists between the multilayered structural body 40 and the n-type semiconductor layer 10, but a lattice mismatch substantially does not exist between the light emitting portion 30 and the multilayered structural body 40. Specifically, the difference between the average lattice constants of the n-type semiconductor layer 10 and the light emitting portion 30 is allotted to the difference between the average lattice constants of the n-type semiconductor layer 10 and the multilayered structural body 40 in order to cause the difference between the average lattice constants of the light emitting portion 30 and the multilayered structural body 40 to substantially not occur. In this configuration, the difference between the average lattice constants of the n-type semiconductor layer 10 and the light emitting portion 30 is reduced by the crystal relaxation of the multilayered structural body 40 that is provided therebetween. The multilayered structural body 40 is not a constituent that directly contributes to luminescence. Therefore, substantially no problems occur as a result of crystal relaxation or the like occurring. Moreover, because the average lattice constant of the light emitting portion 30 along the a-axis is consistent with or close to the average lattice constant of the multilayered structural body 40 along the a-axis, the crystal quality of the light emitting portion 30 can be enhanced.

In the semiconductor light emitting device 110, such a high luminous efficiency is obtained, and thus it is considered that the lattice of the light emitting portion 30 is coherent with the lattice of the multilayered structural body 40.

Hereinafter, to simplify the description, the "lattice constant along the a-axis" will be referred to as simply the "lattice constant". Additionally, in a description of a semiconductor light emitting device having a zinc blend structure (a third reference example and a fourth reference example, described hereinafter), the "lattice constant along the axis along the first direction" will be referred to as simply the "lattice constant".

A structure where the multilayered structural body 40 is provided on a base material semiconductor layer and the light emitting portion 30 is provided thereon is known. However, in this case, an average of a lattice constant of the first layers 41 and an average of a lattice constant of the second layers 42 included in the multilayered structural body 40 is set so as to be closer to a lattice constant of the base material semiconductor layer than to the lattice constant of the light emitting portion 30.

For example, in a semiconductor light emitting device of the third reference example, InP is used for the base material semiconductor layer, the multilayered structural body 40 is provided thereon having alternately stacked first layers 41 of $In_{0.4}Ga_{0.6}As$ with a thickness of about 10 nm and second layers 42 of $In_{0.6}Ga_{0.4}As$ with a thickness of about 10 nm, and the light emitting portion 30 is provided thereon. This light emitting portion 30 includes a bottom clad layer of $In_{0.84}Ga_{0.16}P$, a top clad layer of $In_{0.84}Ga_{0.16}P$, and an active layer of $In_{0.4}Ga_{0.6}As$ provided therebetween. In this configuration, the lattice constant of the second layers 42 is less than the lattice constant of the base material semiconductor layer, and the lattice constant of the first layers 41 is larger than the lattice constant of the base material semiconductor layer. Moreover, the lattice constant of the light emitting portion 30 including the bottom clad layer, the top clad layer, and the active layer is substantially consistent with the lattice constant of the first layers 41. In this multilayered structural body 40, because the lattice constant of the second layers 42 is set to be less than the lattice constant of the base material semiconductor layer, the average lattice constant of the multilayered structural body 40 is reduced to less than the lattice constant of the first layers 41, or, in other words, less than the lattice constant of the light emitting portion 30. Thus, in the third reference example, the average lattice constant of the multilayered structural body 40 is set to be less than the average lattice constant of the light emitting portion 30. Specifically, the average lattice constant of the multilayered structural body 40 is set between the average lattice constant of the light emitting portion 30 and the average lattice constant of the base material semiconductor layer.

For example, in the semiconductor light emitting device of the fourth reference example, GaAs is used as the base material semiconductor layer, the multilayered structural body 40 is provided thereon having alternately stacked first layers 41 of $In_{0.25}Ga_{0.75}P$ and second layers 42 of $In_{0.75}Ga_{0.25}P$, and the light emitting portion 30 is provided thereon. The light emitting portion 30 includes a bottom clad layer of $In_{0.25}Ga_{0.75}P$, a top clad layer of $In_{0.25}Ga_{0.75}P$, and an active layer of $GaAs_{0.6}P_{0.4}$ provided therebetween. In this configuration, the lattice constant of the second layers 42 is larger than the lattice constant of the base material semiconductor layer, and the lattice constant of the first layers 41 is less than the lattice constant of the base material semiconductor layer. Moreover, the lattice constant of the light emitting portion 30 including the bottom clad layer, the top clad layer, and the active layer is substantially consistent with the lattice constant of the first layers 41. In this multilayered structural body 40, the average lattice constant of the multilayered structural body 40 is increased to be larger than the lattice constant of the first layers 41, or in other words, larger than the lattice constant of the light emitting portion 30 because the lattice constant of the second layers 42 is set to be larger than the lattice constant of the base material semiconductor layer. Thus, in the fourth reference example, the average lattice constant of the multilayered structural body 40 is set to be larger than the average lattice constant of the light emitting portion 30. Specifically, the average lattice constant of the multilayered structural body 40 is set between the average lattice constant of the light emitting portion 30 and the average lattice constant of the base material semiconductor layer.

Thus, in the third reference example and the fourth reference example, the setting of the average lattice constant of the multilayered structural body 40 between the average lattice constant of the light emitting portion 30 and the lattice constant of the base material semiconductor layer is an attempt to relax the lattice mismatch between the base material semiconductor layer and the light emitting portion 30. In the third reference example and the fourth reference example like this, just as in the second reference example, the mismatch between the lattice constants of the multilayered structural body 40 and the light emitting portion 30 is large.

On the other hand, in the semiconductor light emitting device 110 according to the embodiment, the average lattice constant of the multilayered structural body 40 is set so as to be larger than a value between the average lattice constant of the light emitting portion 30 and the average lattice constant of the n-type semiconductor layer 10, and the average lattice constant of the multilayered structural body 40 is set to a value that is consistent with or close to the average lattice constant of the light emitting portion 30. Thereby, crystal quality of the light emitting portion 30 can be improved. The above-mentioned phenomenon that the characteristics are improved by setting the average lattice constant of the multilayered structural body 40 to a value consistent with or close to the average lattice constant of the light emitting portion 30 was discovered for the first time from the experimental results described in relation to FIG. 2 and FIGS. 3A to 3C.

Thus, the inventors constructed the configuration of the embodiment based on the phenomenon that was newly discovered from the experiment results described above. This configuration cannot be conceived from the idea of attempting to relax lattice mismatch by setting the average lattice constant of the multilayered structural body 40 between the value of the light emitting portion 30 and the value of the base material semiconductor layer like the third reference example and the fourth reference example described above.

Thus, by setting the average lattice constant of the multilayered structural body 40 to be larger than the average lattice constant of the n-type semiconductor layer 10, making the difference between the average lattice constant of the multilayered structural body 40 and the average lattice constant of the light emitting portion 30 less than the difference between the average lattice constant of the multilayered structural body 40 and the average lattice constant of the n-type semiconductor layer 10, and setting the average lattice constant of the multilayered structural body 40 so as to be consistent with or close to the average lattice constant of the light emitting portion 30, crystal defects can be suppressed and luminous efficiency can be improved.

Specifically, in the semiconductor light emitting device 110 according to the embodiment, strain is relaxed by the multilayered structural body 40 which is disposed nearer to the n-type semiconductor layer 10 than the light emitting portion 30. And the lattice mismatch between the n-type semiconductor layer 10 and the light emitting portion 30 is reduced. Thereby, formation of defects due to strain in the light emitting portion 30 is reduced. Furthermore, a piezoelectric effect can be reduced. As a result, a highly efficient, highly luminous semiconductor light emitting device can be provided.

According to this embodiment, dislocations in crystal growth of the light emitting portion 30 do not easily occur in the region that contributes to luminescence and strain in the well layers 32 is reduced. Thereby, it becomes possible to reduce the piezoelectric effect and to obtain highly efficient luminescence.

In this embodiment, the lattice spacing along the axis in the first direction that is substantially perpendicular to a crystal growth direction (the Z-axis direction) of the multilayered structural body 40 is larger than the lattice spacing along the axis in the first direction of the n-type semiconductor layer 10, and the multilayered structural body 40 and the light emitting portion 30 are pseudomorphic. For example, when growing a c-plane GaN layer, the lattice constant along the axis in the first direction is the lattice constant along the a-axis. The lattice constant along the axis in the first direction may be a lattice constant in the m-axis direction. In other words, a statistic value of the lattice spacing along the axis in the first direction of the multilayered structural body 40 is larger than that of the n-type semiconductor layer 10, and the multilayered structural body 40 and the light emitting portion 30 satisfy pseudomorphic. The same configuration can be applied to nitride semiconductors having an a-plane, an r-plane, an m-plane, a (11-22) plane, a (20-21) plane and other orientations, and nitride semiconductors having zinc blend structures.

In this configuration, the lattice constant of the surface of the multilayered structural body 40 along the a-axis is increased beforehand. Thereby, a portion of the lattice is relaxed while degradation of the flatness of the crystal surface is minimized, and the lattice constant difference with the InGaN layer of the light emitting portion 30 is reduced. Thereby, it becomes possible to form high-quality well layers 32 using InGaN materials.

In the semiconductor light emitting device 110, the In composition ratio among group III elements in the second layers 42 (i.e. the InGaN layer) is preferably lower than the In composition ratio among group III elements in the well layers 32 (i.e. the InGaN layer). Thereby, absorption by the second layers 42 of luminescent light emitted from the well layers 32 can be suppressed.

A thickness of the second layers 42 is preferably not less than 0.5 nm not more than 2.0 nm. A thickness of the first layers 41 is preferably larger than the thickness of the second layers 42.

A number of cycles of the multilayered structural body 40 is preferably 5 or more. In other words, the number of the first layers 41 and the number of the second layers 42 are preferably 5 or more.

A thickness of the multilayered structural body 40 (a total thickness of the plurality of the first layers 41 and the plurality of the second layers 42) is preferably from 20 nm to 1000 nm. If this thickness is less than 20 nm, a distance between the n-type semiconductor layer 10 and the light emitting portion 30 will become excessively close and luminous efficiency will decrease due to crystal defects in the multilayered structural body 40. If this thickness exceeds 1000 nm, the crystal quality of the multilayered structural body 40 will degrade and the characteristics of the light emitting portion 30 that is grown thereon will degrade.

Compositions of each of the plurality of first layers 41 of the multilayered structural body 40 need not be identical. Additionally, compositions of each of the plurality of second layers 42 of the multilayered structural body 40 need not be identical.

The average lattice constant of the multilayered structural body 40 along the a-axis is set to be larger than the average lattice constant of the n-type semiconductor layer 10 along the a-axis by a value not less than 0.01% and not more than 0.03% of the average lattice constant of the n-type semiconductor layer 10 along the a-axis, for example. As described in relation to the experimental results shown in FIGS. 3A to 3C, the average lattice constant of the multilayered structural body 40 along the a-axis is set to be larger than the average lattice constant of the n-type semiconductor layer 10 along the a-axis by a value more than 0.0037%, for example. Thus, for example, the average lattice constant of the multilayered structural body 40 along the a-axis is set to be larger than the average lattice constant of the n-type semiconductor layer 10 along the a-axis by a value not less than 0.004% and not more than 0.03% of the average lattice constant of the n-type semiconductor layer 10 along the a-axis.

In the first layers 41 on the light emitting portion 30 side of the multilayered structural body 40, it is preferable that the lattice constant along the a-axis is larger than the lattice constant of the n-type semiconductor layer 10 and less than the lattice constant of the second layers 42 along the a-axis.

The portion on the light emitting portion 30 side of the multilayered structural body 40 preferably has the same lattice constant as the lattice constant of the InGaN layer including In at an average In composition ratio in the combination (cycle) of one of the first layers 41 and one of the second layers 42. Thereby, the lattice constant along the a-axis can be efficiently changed while maintaining the flatness of the surface (face of the light emitting portion 30 side) of the multilayered structural body 40.

An average In composition ratio in the multilayered structural body 40 (multilayered structural body average In composition ratio A1) is preferably less than or equal to an average In composition ratio in the light emitting portion 30 (light emitting portion average In composition ratio A2).

A number of the plurality of first layers 41 is defined as N1 (where "N1" is an integer greater than or equal to 2). An ith first layer 41 (where "i" is an integer greater than or equal to 2 and less than or equal to N1) of the plurality of the first layers 41 has an In composition ratio $x1_i$ among group III elements (ratio of number of atoms of In among group III elements) and a layer thickness $t1_i$ (nanometers).

A number of the plurality of second layers 42 is defined as N2 (where "N2" is an integer greater than or equal to 2). A jth second layer 42 (where "j" is an integer greater than or equal to 2 and less than or equal to N2) of the plurality of the second layers 42 has an In composition ratio $x2_j$ among group III elements (ratio of number of atoms of In among group III elements) and a layer thickness $t2_j$ (nanometers). N1 is the same as N2. Additionally, an absolute value of a difference between N1 and N2 is 1.

A number of the plurality of barrier layers 31 is defined as N3 (where "N3" is an integer greater than or equal to 2). A kth barrier layer 31 (where "k" is an integer greater than or equal to 2 and less than or equal to N3) of the plurality of the barrier layers 31 has an In composition ratio $x3_k$ among group III elements (ratio of number of atoms of In among group III elements) and a layer thickness $t3_k$ (nanometers).

A number of the plurality of the well layers 32 is defined as N4 (where "N4" is an integer greater than or equal to 2). An lth well layer 32 (where "l" is an integer greater than or equal to 2 and less than or equal to N4) of the plurality of the well layers 32 has an In composition ratio $x4_l$ among group III elements (ratio of number of atoms of In among group III elements) and a layer thickness $t4_l$ (nanometers). N3 can be made the same as N4. Additionally, N3 is greater than N4 by 1.

The multilayered structural body average In composition ratio A1 can be expressed by the following formula 1.

$$A1 = \frac{\sum_{i=1}^{N1}(x1_i \cdot t1_i) + \sum_{j=1}^{N2}(x2_j \cdot t2_j)}{\sum_{i=1}^{N1}t1_i + \sum_{j=1}^{N2}t2_j} \quad \cdots \quad (1)$$

The light emitting portion average In composition ratio A2 can be expressed by the following formula 2.

$$A2 = \frac{\sum_{k=1}^{N3}(x3_k \cdot t3_k) + \sum_{l=1}^{N4}(x4_l \cdot t4_l)}{\sum_{k=1}^{N3}t3_k + \sum_{l=1}^{N4}t4_l} \quad \cdots \quad (2)$$

Here, the multilayered structural body average In composition ratio A1 is preferably set so as to be less than or equal to the light emitting portion average In composition ratio A2. This is more preferable because excessive strain will not be easily generated by setting the lattice constant of a material included in the multilayered structural body 40 along the a-axis between the lattice constant along the a-axis of a material included in the light emitting portion 30 and the lattice constant of the n-type semiconductor layer 10 along the a-axis.

If the multilayered structural body average In composition ratio A1 becomes larger than the light emitting portion average In composition ratio A2, excessive strain will be generated in the multilayered structural body 40 and the characteristics will easily degrade.

The multilayered structural body average In composition ratio A1 is preferably close to the light emitting portion average In composition ratio A2. It is more preferable to set the lattice constant of the material included in the multilayered structural body 40 along the a-axis to be close to the lattice constant of the material included in the light emitting portion 30 along the a-axis because the generation of excessive strain will be further suppressed. When a ratio of an absolute value of a difference between the multilayered structural body average In composition ratio A1 and the light emitting portion average In composition ratio A2 to the multilayered structural body average In composition ratio A1 is defined as an In composition difference ratio RA (RA=|A1-A2|/A1), the In composition difference ratio RA is preferably small. The In composition difference ratio RA is preferably less than 1.

For example, in the semiconductor light emitting device 110 described above according to the embodiment, the multilayered structural body average In composition ratio A1 is 0.0240 and the light emitting portion average In composition ratio A2 is 0.0242. In the semiconductor light emitting device 119b of the second reference example, the multilayered structural body average In composition ratio A1 is 0.019 and the light emitting portion average In composition ratio A2 is 0.0242.

The In composition difference ratio RA of the semiconductor light emitting device 110 is 0.008 and the In composition difference ratio RA of the semiconductor light emitting device 119b is 0.273. In the semiconductor light emitting device 110, the In composition difference ratio RA is larger than the absolute value of the difference (in this example, 4 ppm) between the average lattice constant of the multilayered structural body 40 along the a-axis and the average lattice constant of the light emitting portion 30 along the a-axis. In other words, in the embodiment, the difference in the average In composition ratios of the multilayered structural body 40 and the light emitting portion 30 is smaller than the difference between the average lattice constants of the multilayered structural body 40 and the light emitting portion 30 in the a-axes.

Thus, in the semiconductor light emitting device 110 according to the embodiment, the multilayered structural body average In composition ratio A1 is set to a value close to (or a value equal to) the light emitting portion average In composition ratio A2. The lattice of the light emitting portion 30 becomes coherent with the lattice of the multilayered structural body 40.

In this embodiment, the average lattice constant of the multilayered structural body 40 along the a-axis is set to be larger than the average lattice constant of the n-type semiconductor layer 10 along the a-axis while the absolute value of the difference between the average lattice constant of the multilayered structural body 40 along the a-axis and the average lattice constant of the light emitting portion 30 along the a-axis is set to be less than the absolute value of the difference between the average lattice constant of the multilayered structural body 40 along the a-axis and the average lattice constant of the n-type semiconductor layer 10 along the a-axis. As far as this condition is satisfied, a relationship between the In composition ratio in the second layers 42 and the In composition ratio in the well layers 32 is arbitrary. For example, in the semiconductor light emitting device 110 described above, the In composition ratio (0.1) in the second layers 42 is less than the In composition ratio (0.2) in the well layers 32. Additionally, in this embodiment, the In composition ratio in the second layers 42 may be set so as to be higher than or equal to the In composition ratio in the well layers 32.

Lattice mismatch between the light emitting portion 30 and the n-type semiconductor layer 10 increases when the In composition ratio in the well layers 32 of the light emitting portion 30 increases. Specifically, the lattice mismatch for a wavelength of the luminescent light from the light emitting portion 30 of green becomes larger than that of blue. Therefore, the effect of improving the crystal quality of the light emitting portion 30, obtained when applying this embodiment, is exerted more effectively when the wavelength of the luminescent light is long.

For example, a dominant wavelength of the luminescent light emitted from the light emitting portion 30 is preferably not less than 400 nm and not more than 700 nm. Furthermore, it is more preferable that the dominant wavelength is not less than 440 nm and not more than 550 nm. For example, the In composition ratio in the well layers 32 is preferably not less than 0.1 and not more than 0.5. Furthermore, it is more preferable that the In composition ratio is not less than 0.15 and not more than 0.25.

In such a configuration, lattice mismatch between the light emitting portion 30 and the n-type semiconductor layer 10 is especially large and the effect of improving the crystal quality is especially effectively exerted.

In the embodiment, a band gap energy of the multilayered structural body 40 is preferably larger than a band gap energy of the light emitting portion 30. Thereby, emission of unintended light in the multilayered structural body 40 is suppressed and absorption of the light emitted from the light emitting portion 30 by the multilayered structural body 40 is suppressed. Furthermore, it is further preferable that the band gap energy of the multilayered structural body 40 is smaller than a band gap energy of the n-type semiconductor layer 10, and an absolute value of a difference between the band gap energy of the multilayered structural body 40 and the band gap energy of the n-type semiconductor layer 10 is smaller than an absolute value of a difference between the band gap energy of the light emitting portion 30 and the band gap energy of the n-type semiconductor layer 10. Thereby, the functioning of at least either of the first layers 41 and the second layers 42 included in the multilayered structural body 40 as a barrier layer is prevented. Thereby, an increase in an operation voltage caused by the providing of the multilayered structural body 40 can be suppressed.

A peak wavelength of the light emitted from the light emitting portion 30 of the semiconductor light emitting device 110 was 520 nm. On the other hand, a sample with a structure having the same multilayered structural body 40 as the semiconductor light emitting device 110 but not having the light emitting portion 30 was fabricated. Photoluminescence of the sample was measured and the peak wavelength of the luminescence from the multilayered structural body 40 was 381 nm. A peak wavelength of the luminescence from the multilayered structural body 40 is sufficiently shorter (band gap energy is larger) than a peak wavelength of the luminescence from the light emitting portion 30 of the semiconductor light emitting device 110, and is close to a 365 nm of the GaN of the base material semiconductor layer (n-type semiconductor layer 10).

Various modifications of the semiconductor light emitting device 110 according to the embodiment are possible.

For example, the first layer 41 may be disposed on the side closest to the n-type semiconductor layer 10 in the multilayered structural body 40; and then the second layers 42 and the first layers 41 may be alternately stacked; further, the first layer 41 may be disposed on the side closest to the light emitting portion 30 in the multilayered structural body 40. In this case, for example, the well layer 32 may be disposed, or the barrier layer 31 may be disposed, on the side closest to the multilayered structural body 40 in the light emitting portion 30.

For example, the second layer 42 may be disposed on the side closest to the n-type semiconductor layer 10 in the multilayered structural body 40; and then the first layers 41 and the second layers 42 may be alternately stacked. Furthermore, the second layer 42 may be disposed on the side closest to the light emitting portion 30 in the multilayered structural body 40. In this case, for example, the well layer 32 may be disposed, or the barrier layer 31 may be disposed, on the side closest to the multilayered structural body 40 in the light emitting portion 30.

The method described above as a method for manufacturing the semiconductor light emitting device 110 is an example of a method for manufacturing a semiconductor light emitting device according to the embodiment, and different variations of the manufacturing method are possible.

For example, any method used to grow a nitride semiconductor can be employed for the crystal growth.

TMGa (trimethylgallium), TEGa (triethylgallium), and the like can be used, for example, as a source of the Ga. TMIn (trimethylindium), TEIn (triethylindium), and the like can be used, for example, as a source of the In. TMAl (trimethyl aluminum) and the like can be used, for example, as a source of the Al. $NH_3$(ammonia), MMHy (monomethylhydrazine), DMHy (dimethylhydrazine), and the like can be used, for example, as a source of the N. $SiH_4$ (monosilane) and the like can be used, for example, as a source of the Si. $Cp_2Mg$ (bis-cyclopentadienyl magnesium) and the like can be used, for example, as a source of the Mg. However, this embodiment is not limited thereto, and any material appropriate for each element can be used.

The semiconductor light emitting device of this embodiment can be applied to LEDs. The LED as described above can be applied to display devices, lighting devices, and the like. Additionally, the semiconductor light emitting device according to the embodiment can be applied to, for example, laser diodes (LD) and the like that are used as light sources for reading and writing high density storage disks.

According to this embodiment, a semiconductor light emitting device wherein crystal strain is suppressed can be provided.

Note that in this specification, the term, "nitride semiconductor" includes semiconductors of all compositions wherein composition ratios of x, y, and z in the formula $B_xIn_yAl_zGa_{1-x-y-z}N$ fall within the respective ranges of $0 \leq x \leq 1$, $0 \leq y \leq 1$, $0 \leq z \leq 1$, and $x+y+z \leq 1$. Furthermore, with the formula described above, "nitride semiconductors" shall also be understood to include semiconductors further including group V elements other than N (nitrogen), semiconductors further including various elements added to control various physical characteristics such as conductivity type and the like, and semiconductors further including various elements that are included unintentionally.

In this specification, "perpendicular" and "parallel" are not used to mean perpendicular and parallel in their narrowest sense, but rather substantially perpendicular or parallel so as to take factors into account such as variations in manufacturing processes and the like.

An embodiment of the invention with reference to examples was described above. However, the invention is not limited to these examples. The scope of the invention includes all cases in which, for example, a person skilled in the art could make use of publicly known information to appropriately select configuration elements such as the substrate, buffer layers, n-type semiconductor layers, p-type semiconductor layers, light emitting portions, barrier layers, well layers, stacked structural body, and the like included in the semiconductor light emitting device provided that the obtained effects are similar. Additionally, combinations of elements from two or more of the examples are also included in the scope of the invention, provided they are technically possible and do not depart from the spirit of the invention.

Beside such cases, all semiconductor light emitting devices based on the embodiments of the invention described above that are obtainable through appropriate design modifications by a person skilled in the art shall be understood to fall within the scope of the invention, provided such semiconductor light emitting devices do not depart from the spirit of the invention.

Furthermore, regarding the scope of the spirit of the invention, it is understood that a variety of variations and modifications could be conceived by a person skilled in the art and that these variations and modifications all fall within the scope of the invention as well.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

**Claims**

1.  A semiconductor light emitting device (110) comprising:

    an n-type semiconductor layer (10) including a nitride semiconductor;
    a p-type semiconductor layer (20) including a nitride semiconductor;
    a multilayered structural body (40) provided between the n-type semiconductor layer (10) and the p-type semiconductor layer (20), the multilayered structural body (40) including a plurality of first layers (41) and a second layer (42) provided between the plurality of first layers (41) , the second layer (42) including In; and
    a light emitting portion (30) being in contact with the multilayered structural body (40) between the multilayered structural body (40) and the p-type semiconductor layer (20), the light emitting portion (30) including a plurality of barrier layers (31) and a well layer (32) provided between the plurality of barrier layers (31) , the well layer (32) including In with an In composition ratio among group III elements higher than an In composition ratio among group III elements in the second layer (42),
    an average lattice constant of the multilayered structural body (40) along an axis in a first direction perpendicular to a stacking direction from the n-type semiconductor (10) layer toward the p-type semiconductor layer (20) being larger than an average lattice constant of the n-type semiconductor layer (10) along an axis in the first direction, and
    an absolute value of a difference between the average lattice constant of the multilayered structural body (40) and an average lattice constant of the light emitting portion (30) along an axis in the first direction being less than an absolute value of a difference between the average lattice constant of the multilayered structural body (40) and the average lattice constant of the n-type semiconductor layer (10).

2.  The device (110) according to claim 1, wherein a lattice of the light emitting portion (30) is coherent with a lattice of the multilayered structural body (40).

3.  The device (110) according to any of claim 1 and claim 2, wherein
    a number of the plurality of first layers (41) is N1 (where N1 is an integer greater than or equal to 2), and an ith first layer (where i is an integer greater than or equal to 2 and less than or equal to N1) of the plurality of the first layers (41) has an In composition ratio $x1_i$ among group III elements, and the ith first layer has a layer thickness $t1_i$ (nanometers),
    a number of the plurality of second layers (42) is N2 (where N2 is an integer greater than or equal to 2), and a jth second layer (where j is an integer greater than or equal to 2 and less than or equal to N2) of the plurality of the second layers (42) has an In composition ratio $x2_j$ among group III elements, and the jth second layer has a layer thickness $t2_j$ (nanometers),
    a number of the plurality of barrier layers (31) is N3 (where N3 is an integer greater than or equal to 2), and a kth barrier layer (where k is an integer greater than or equal to 2 and less than or equal to N3) of the plurality of the barrier layers (31) has an In composition ratio $x3_k$ among group III elements, and the kth barrier layer has a layer thickness $t3_k$ (nanometers),
    a number of the plurality of well layers (32) is N4 (where N4 is an integer greater than or equal to 2), and an Ith well layer (where I is an integer greater than or equal to 2 and less than or equal to N4) of the plurality of the well layers (32) has an In composition ratio $x4_I$ among group III elements, and the Ith well layer has a layer thickness $t4_I$ (nanometers), and when
    a multilayered structural body average In composition ratio A1 is expressed as

$$A1 = \frac{\sum_{i=1}^{N1}(x1_i \cdot t1_i) + \sum_{j=1}^{N2}(x2_j \cdot t2_j)}{\sum_{i=1}^{N1} t1_i + \sum_{j=1}^{N2} t2_j}$$

and a light emitting portion average In composition ratio A2 is expressed as

$$A2 = \frac{\sum_{k=1}^{N3}(x3_k \cdot t3_k) + \sum_{l=1}^{N4}(x4_l \cdot t4_l)}{\sum_{k=1}^{N3} t3_k + \sum_{l=1}^{N4} t4_l}$$

the multilayered structural body average In composition ratio A1 is less than or equal to the light emitting portion average In composition ratio A2.

4. The device (110) according to claim 3, wherein a ratio of an absolute value of a difference between the multilayered structural body average In composition ratio A1 and the light emitting portion average In composition ratio A2 to the multilayered structural body average In composition ratio A1 is less than 1.

5. The device (110) according to any of claims 1-4, wherein the In composition ratio in the well layer (32) is not less than 0.15 and not more than 0.25.

6. The device (110) according to any of claims 1-5, wherein a band gap energy of the multilayered structural body (40) is larger than a band gap energy of the light emitting portion (30).

7. The device (110) according to claim 6, wherein the band gap energy of the multilayered structural body (40) is smaller than a band gap energy of the n-type semiconductor layer (10), and an absolute value of a difference between the band gap energy of the multilayered structural body (40) and the band gap energy of the n-type semiconductor layer (10) is smaller than an absolute value of a difference between the band gap energy of the light emitting portion (30) and the band gap energy of the n-type semiconductor layer (10).

8. The device (110) according to any of claims 1-7, wherein a thickness of the multilayered structural body (40) is not less than 20 nanometers and not more than 1000 nanometers.

9. The device (110) according to any of claims 1-8, wherein the average lattice constant of the multilayered structural body (40) is larger than the average lattice constant of the n-type semiconductor (10) by a value not less than 0.004% and not more than 0.03% of the average lattice constant of the n-type semiconductor layer (10).

10. The device (110) according to any of claims 1-9, wherein a thickness of the first layer (41) is larger than a thickness of the second layer (42).

11. The device (110) according to any of claims 1-10, wherein a thickness of the second layer (42) is not less than 0.5 nanometers and not more than 20 nanometers.

12. The device (110) according to any of claims 1-11, wherein the second layer (42) is provided multiply and a number of the first layers (41) and a number of the second layers (42) are not less than five.

13. The device (110) according to any of claims 1-12, wherein the first layer (41) includes GaN and the second layer (42) includes InGaN.

**14.** The device (110) according to any of claims 1-13, wherein a dominant wavelength of a luminescent light emitted from the light emitting portion (30) is not less than 400 nanometers and not more than 700 nanometers.

**15.** The device (110) according to any of claims 1-13, wherein a dominant wavelength of a luminescent light emitted from the light emitting portion (30) is not less than 440 nanometers and not more than 550 nanometers.

**16.** The device (110) according to any of claims 1-15, wherein a thickness of the plurality of barrier layers (31) is larger than a thickness of the well layer (32).

**17.** The device (110) according to any of claims 1-16, wherein a thickness of the plurality of barrier layers (31) is not less than 3 nanometers and not more than 20 nanometers.

**18.** The device (110) according to any of claims 1-17, wherein the multilayered structural body (40) is formed on the n-type semiconductor layer (10) , the light emitting portion (30) is formed on the multilayered structural body (40), and the p-type semiconductor layer (20) is formed on the light emitting portion (30).

**19.** The device (110) according to any of claims 1-18, further comprising:

a substrate (5); and
a buffer layer (6),
the n-type semiconductor layer (10) being disposed between the multilayered structural body (40) and the substrate (5),
the buffer layer (6) being disposed between the substrate (5) and the n-type semiconductor layer (10).

**20.** The device (110) according to claim 19, wherein a major surface of the substrate (5) is a (0001) plane of a sapphire.

FIG. 1

FIG. 2

FIG. 3A

FIG. 3B

FIG. 3C